Europäisches Patentamt

European Patent Office

Office européen des brevets

(19)

(11) Numéro de publication: **0 305 268**
A1

# (12) DEMANDE DE BREVET EUROPEEN

(21) Numéro de dépôt: **88402100.7**

(22) Date de dépôt: **12.08.88**

(51) Int. Cl.⁴: **H 01 L 21/306**
H 01 L 21/31

(30) Priorité: **18.08.87 FR 8711670**

(43) Date de publication de la demande:
**01.03.89 Bulletin 89/09**

(84) Etats contractants désignés:
**BE CH DE ES FR GB IT LI NL SE**

(71) Demandeur: **L'AIR LIQUIDE, SOCIETE ANONYME POUR L'ETUDE ET L'EXPLOITATION DES PROCEDES GEORGES CLAUDE**
**75, Quai d'Orsay**
**F-75321 Paris Cédex 07 (FR)**

(72) Inventeur: **Rufin, Denis**
**Chicago Research Center 5230 S. East Ave.**
**Countryside IL 60525 (US)**

**Hirase, Ikuo**
**L'Air Liquide Lab. 5-9-9, Tokodai, Toyosato-machi**
**Tsucuba-gun Ibaraki-Pref.-300-26 (JP)**

(74) Mandataire: **Vesin, Jacques et al**
**L'AIR LIQUIDE, SOCIETE ANONYME POUR L'ETUDE ET L'EXPLOITATION DES PROCEDES GEORGES CLAUDE**
**75, quai d'Orsay**
**F-75321 Paris Cédex 07 (FR)**

(54) Procédé de gravure ionique réactive à basse tension d'autopolarisation par addition de gaz inertes.

(57) La présente invention concerne un procédé de gravure ionique réactive à basse tension d'autopolarisation, caractérisé en ce que le gaz de gravure injecté comporte 100 % de gaz inerte, et notamment d'hélium et/ou de néon.

EP 0 305 268 A1

**Description**

**"PROCEDE DE GRAVURE IONIQUE REACTIVE A BASSE TENSION D'AUTOPOLARISATION PAR ADDITION DE GAZ INERTES"**

La présente invention concerne un procédé de gravure ionique réactive pour la fabrication de composants électroniques.

La gravure ionique réactive consiste à éliminer, en certains emplacements seulement, la couche de matériau, par exemple de silice, préalablement déposée sur le substrat en matériau différent, par exemple en silicium (sous-couche), les emplacements étant définis par un masque en résine déposé sur la couche.

La tranche de silicium partiellement masquée est soumise à un plasma créé entre deux électrodes en vis à vis dont l'une, l'électrode-support (cathode) où sont disposées les tranches à graver, est couplée à un générateur de puissance RF et l'autre est reliée à la masse.

Les radicaux et espèces neutres participent à des réactions chimiques à la surface exposée au plasma pour produire des espèces volatiles ou des précurseurs. Les ions positifs du plasma sont extraits et accelérés dans la région proche de l'électrode recevant la puissance RF. Ils bombardent la surface des tranches à graver, activent les mécanismes d'adsorption et de désorption et les réactions chimiques qui ont lieu à la surface du matériau à graver exposé au plasma.

DAns le procédé de gravure ionique réactive, la cathode se charge négativement par rapport au plasma. En effet, les électrons ont une plus grande mobilité que les ions infiniments plus lourds, et le plasma est formé à partir d'une source alternative de courant (typiquement 13,56 MHz).

La vitesse de gravure est liée à la valeur de cette tension d'autopolarisation, sensiblement constante (typiquement de quelques centaines de volts à 1000V), qui est elle-même liée aux paramètres traditionnels du plasma : puissance RF, distance inter électrode, pression, forme des électrodes, matériaux isolants etc...

La sélectivité de la gravure, c'est à dire le fait que seule la couche ($SiO_2$) doit être éliminée, sans que la sous-couche (Si) soit atteinte, et l'état uniforme de la surface gravée sont deux critères essentiels de la qualité de la gravure.

Il a été établi qu'une tension d'autopolarisation trop élevée conduit à des défauts électriques et cristallins dans les couches exposées au bombardement des ions. Ces défauts induisent des inconvénients majeurs pour les dispositifs ultérieurs (mémoires) comme des défauts d'isolation entre parties conductrices, des courants de fuites, des déplacements des tensions de commande, par exemple.

Une possibilité pour opérer à basse tension consiste à réduire la puissance. Cependant opérer à basse puissance revient à diminuer la vitesse de gravure.

La présente invention propose une autre solution qui consiste à opérer à forte pression.

Ainsi, la présente invention concerne un procédé de gravure ionique réactive, caractérisé en ce que la gaz de gravure injecté comporte de 1 à 100 % de gaz inerte.

En effet, la demanderesse a mis en évidence que lors d'une élévation de pression, pour un mélange gazeux et une puissance donnés, la tension d'autopolarisation descend.

Le gaz inerte, c'est-à-dire non chimiquement actif sous l'effet du plasma, modifie le comportement collisionnel des ions, mais n'affecte pas la vitesse de gravure. C'est donc un gaz inerte que l'on injecte en plus des gaz actifs pour opérer à plus haute pression.

Comme gaz inerte, on peut employer selon l'invention, des gaz rares, comme l'hélium, le néon ou l'argon ou leurs mélanges, et de préférence l'hélium ou le néon.

Pour la mise en oeuvre du procédé, on utilise des réacteurs classiques pour gravure ionique réactive et on peut injecter, outre le gaz inerte selon l'invention, les gaz usuels de gravure. Ces gaz de gravure sont classiquement des fluorocarbonés, comme $CF_4$, $C_2F_6$, $CH\,F_3$ et/ou des hydrocarbures ($CH_4$, $C_2H_6$) et/ou l'hydrogène.

De préférence, les gaz de gravure selon l'invention comportent 75% à 90% de gaz inerte, sans que ces valeurs soient limitatives.

Ainsi, dans le cas où les espèces chimiques réactives proviennent de l'action du plasma sur la surface recouverte de polytétrafluoréthylène d'une partie du réacteur, et en particulier de l'électrode-support, on peut utiliser 100% de gaz inerte. Ce mode de mise en oeuvre présente l'avantage que la durée de vie des huiles des pompes Rotary ont prolongée, les gaz effluents ne comportant pas d'acide fluorhydrique.

D'autres avantages et caractéristiques de l'invention apparaîtront à la lecture de la description des figures ci-après :

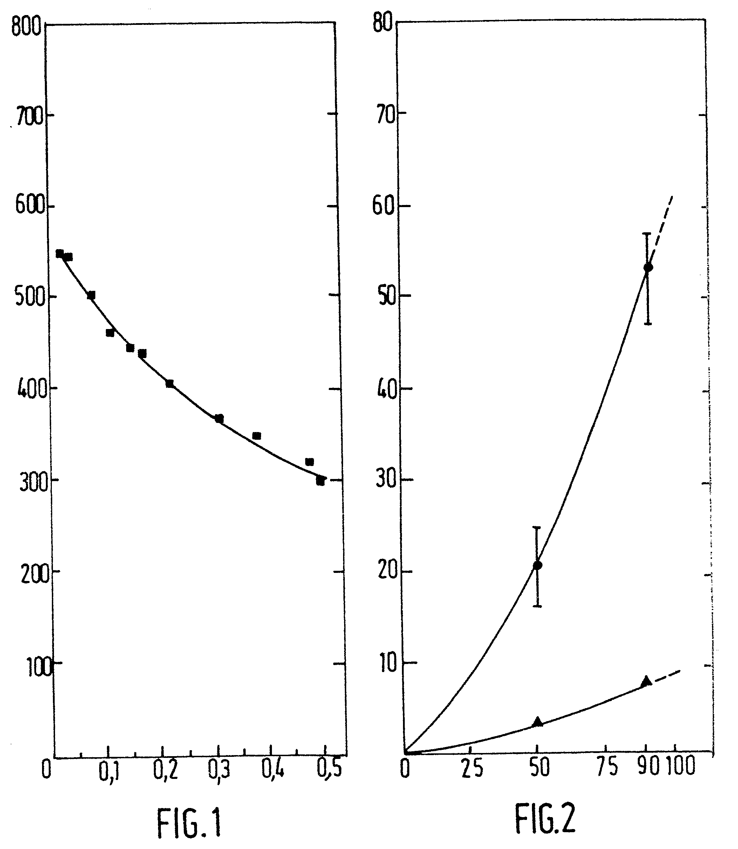

- la figure 1 représente la tension d'autopolarisation (en V) qui diminue en fonction de la pression croissante en torr (1 torr = 1,333 $10^2$ Pa), pour une puissance de 800 W, une distance interélectrode de 32 mm, et une mélange gazeux comportant 8 % de $CF_4$, 2 % de $CH_4$, et 90 % d'He, en l'absence de tranche à graver ;

- la figure 2 représente la vitesse de gravure (en nm/mm) en fonction de la concentration en hélium (%) du mélange gazeux, pour $SiO_2$ (points) et Si (triangles), pour une puissance de 800 W, une pression de 0,5 x 1,333 $10^2$ Pa, une distance interélectrode de 32 mm et un mélange gazeux initial $CH_4/CF_4$ comportant 20 % de $CH_4$ et des pourcentages croissants en hélium ; elle met en évidence que dans des conditions données de puissance et de pression, le rapport de la vitesse de gravure de $SiO_2$ sur celle de Si est favorable à la sélectivité, et ce d'autant plus à de hauts pourcentages en hélium ;

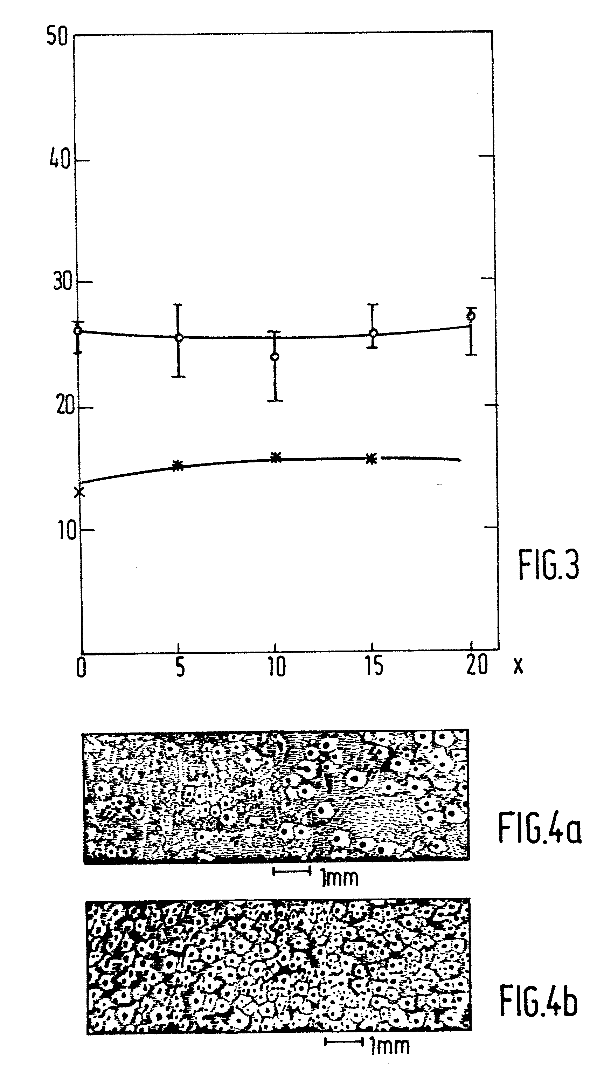

- la figure 3 représente la vitesse de gravure en nm/mn) en fonction de la concentration en hélium (x) pour $SiO_2$ (points) et la résine positive du type AZ 1350 (étoiles) pour une puissance de 800W, à une pression de 0,03 x 1,333 $10^2$ Pa, pour une distance interélectrode de 32 mm et un mélange gazeux définis par des débits de 34 cm³ standard/mn de $CF_4$, 6 cm³ standard/mn de $CH_4$, et une concentration en hélium (100 x/40) variant de 0 à 20 % ; elle met en évidence que l'hélium n'a pas d'influence sur la gravure ni de $SiO_2$, ni de la résine.

- les figures 4a et b représentent l'état de surface de tranche de silicium après la gravure, a : avec hélium (90%) et un mélange $CF_4/CH_4$ (85/15), et b : sans hélium et le même mélange ; les défauts cristallins apparaissent en plus grand nombre après le traitement sans hélium.

**Revendications**

1. - Procédé de gravure ionique réactive, caractérisé en ce que la gaz de gravure injecté comporte de 1 à 100 % de gaz inerte.

2. - Procédé selon la revendication 1, caractérisé en ce que le gaz inerte est choisi parmi les gaz rares et leurs mélanges.

3. - Procédé selon la revendication 1 ou 2, caractérisé en ce que le gaz inerte est choisi parmi l'hélium et le néon.

4. - Procédé selon l'une des revendications 1 à 3, caractérisé en ce que le gaz de gravure comporte de 75 à 90% de gaz inerte, notamment d'hélium et/ou de néon.

5. - Procédé selon l'une des revendications 1 à 4, caractérisé en ce que le gaz inerte est l'hélium.

6. - Procédé selon la revendication 1 à 3, caractérisé en ce que le gaz de gravure injecté comporte 100 % de gaz inerte et en ce qu'au moins une partie du réacteur est en polytétrafluoréthylène.

7. - Procédé selon la revendication 6, caractérisé en ce que le gaz de gravure injecté comporte 100% d'hélium.

8. - Procédé selon la revendication 6 ou 7, caractérisé en ce que l'électrode - support est recouverte de polytétrafluoréthylène.

FIG.1

FIG.2

FIG.3

FIG.4a

1mm

FIG.4b

1mm

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | J. ELECTROCHEM. SOC.: SOLID-STATE SCIENCE AND TECHNOLOGY, vol. 128, no. 10, octobre 1981, pages 2174-2179; N.J. IANNO et al.: "Comparison of the etching and plasma characteristics of discharges in CF4 and NF3" * Figures 3,6; conclusions * | 1-5 | H 01 L 21/306 H 01 L 21/31 |
| X | DE-A-3 118 839 (HITACHI) * Revendications 1-7 * | 1-8 | |
| X | EXTENDED ABSTRACTS, vol. 83-1, mai 1983, pages 235-236, revendication no. 147; E. LAES et al.: "Characterization of siliconnitride dry etching in SF6-He mixtures" * Figures 2,5; conclusions * | 1-5 | |
| X | SOLID STATE TECHNOLOGY, vol. 27, no. 5, mai 1984, pages 203-206; R.N. CASTELLANO: "Profile control in plasma etching of SiO2" * Page 203, colonne 2, paragraphe 3 - page 204, colonne 2, paragraphe 1; figures 1-3 * | 1-5 | |

DOMAINES TECHNIQUES RECHERCHES (Int. Cl.4)

H 01 L

Le présent rapport a été établi pour toutes les revendications

| Lieu de la recherche | Date d'achèvement de la recherche | Examinateur |
|---|---|---|
| LA HAYE | 03-11-1988 | VANCRAEYNEST F.H. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...............................................................................................
& : membre de la même famille, document correspondant

EPO FORM 1503 03.82 (P0402)